# EUROPEAN PATENT APPLICATION

(11) **EP 4 727 294 A1**
(43) Date of publication of application: **15.04.2026**
(21) Application number: 24844238.6
(22) Date of filing: 11.03.2024
(51) Int. Cl.: H10D 84/90, H05K 7/14

(54) **CHIP, CHIP MANUFACTURING METHOD, COMPUTING DEVICE, AND SIGNAL TRANSMISSION METHOD**

(30) Priority: 21.07.2023 CN 202310905856
(71) Applicant: Huawei Technologies Co., Ltd., Shenzhen, Guangdong 518129 (CN)
(72) Inventor: XU, Yahan, Shenzhen, Guangdong 518129 (CN); PENG, Xiping, Shenzhen, Guangdong 518129 (CN); FU, Junhao, Shenzhen, Guangdong 518129 (CN)
(74) Representative: Gill Jennings & Every LLP
(86) International application number: PCT/CN2024/080986
(87) International publication number: WO 2025/020541

(57) **Abstract**

A chip, a chip manufacturing method, a computing device, and a signal transmission method are provided. A package substrate of the chip includes a basic pattern with six signal pins. A first pin, a second pin, a third pin, and a fourth pin in the six signal pins are sequentially spaced apart in a first direction, and a fifth pin and a sixth pin are spaced apart in a second direction. The fifth pin and the sixth pin are respectively located on two sides of a connection line between the second pin and the third pin. The first pin, the fourth pin, the fifth pin, and the sixth pin are data signal pins, and the second pin and the third pin are control signal pins. In this solution, the data signal pins are respectively arranged at four extension ends of a cross-shaped pattern, the data signal pins are far away from each other, and each data signal pin has no adjacent data signal pin that may form a crosstalk source. In this way, electromagnetic crosstalk between pins can be effectively reduced. In addition, density of a pinmap can be improved, and a package area can be reduced.

## Description

This application claims priority to Chinese Patent Application No. 202310905856.2, filed with the China National Intellectual Property Administration on July 21, 2023, and entitled "CHIP, CHIP MANUFACTURING METHOD, COMPUTING DEVICE, AND SIGNAL TRANSMISSION METHOD", which is incorporated herein by reference in its entirety.

### TECHNICAL FIELD

Embodiments of this application relate to the field of electronic component packaging, and in particular, to a chip, a chip manufacturing method, a computing device, and a signal transmission method.

### BACKGROUND

With continuous development of storage technologies, a double data rate synchronous dynamic random access memory (DDR SDRAM, double data rate synchronous dynamic random access memory) system is widely used in computing products, for example, but not limited to a server product. However, with evolution of DDR generations, performance improvement of the DDR system imposes higher requirements on chip packaging technologies.

In the DDR system, an increasing quantity of channels leads to more input/output (input/output, I/O) pins, resulting in an increasingly large chip package size. A larger package size usually means a larger volume and a greater mass, and more heat is generated during welding of a chip to a printed circuit board (PCB, Printed Circuit Board). Most chip packages have material thermal expansion coefficients different from that of the PCB. In this case, a large welding temperature gradient is caused, resulting in thermal stress and thermal fatigue, and increasing a risk of a welding point. In addition, it is difficult to control deformation of a large-sized package, which may cause welding defects and poor connections, directly affecting costs and a yield of products.

Moreover, a rate of a DDR interface becomes increasingly high, which has a greater impact on crosstalk between adjacent signals. To reduce electromagnetic crosstalk between pins, a typical processing manner is to dispose ground solder balls around pins of a chip package substrate. This can reduce an impact of electromagnetic crosstalk, but increases a size of a chip.

Therefore, for a pinmap of the chip package substrate, two trend design requirements need to be considered: high density and low crosstalk, to meet performance requirements of products.

### SUMMARY

Embodiments of this application provide a chip, a chip manufacturing method, a computing device, and a signal transmission method, to improve pinmap density and effectively reduce electromagnetic crosstalk.

A first aspect of embodiments of this application provides a chip. A die of the chip is disposed on a package substrate of the chip, and the package substrate is a carrier for packaging the die. A plurality of pinmap patterns are disposed in a pin region of the package substrate, and at least two pinmap patterns in the plurality of pinmap patterns are basic patterns including six signal pins. A first pin, a second pin, a third pin, and a fourth pin in the six signal pins of the basic pattern are sequentially spaced apart in a first direction, a fifth pin and a sixth pin in the six signal pins are spaced apart in a second direction, the first direction is different from the second direction, and the fifth pin and the sixth pin are respectively located on two sides of a connection line between the second pin and the third pin. In addition, the first pin, the fourth pin, the fifth pin, and the sixth pin are data signal pins, and the second pin and the third pin are control signal pins.

In this way, the pins of the basic pattern are arranged in a cross-shaped form. The four data signal pins are respectively arranged at four extension ends of the cross-shaped pattern, and the control signal pins are arranged in the middle of the cross-shaped pattern. The data signal pins are far away from each other, and each data signal pin has no adjacent data signal pin that may form a crosstalk source, thereby effectively avoiding an impact of electromagnetic crosstalk between adjacent data signal pins. This pinmap (Pinmap) solution effectively reduces the electromagnetic crosstalk between pins, and supports a higher DDR running rate. In addition, this pinmap solution can improve pinmap density and reduce a package area, thereby providing technical assurance for further improving a product yield and reducing processing costs.

For example, pins in the pin region of the package substrate may be of a solder ball structure, and are electrically connected to a corresponding pad on a circuit board through welding. The pins in the pin region of the package substrate may alternatively be of a metal contact structure. A metal spring is correspondingly disposed on the circuit board, and one metal contact may be disposed corresponding to one metal spring. An assembled metal contact presses against the metal spring, and a reliable electrical connection to the adapted metal contact is maintained through the deformed metal spring.

During actual application, the plurality of pinmap patterns in the pin region of the package substrate may be configured as pinmaps in different forms based on actual function requirements. For example, a part of pinmap patterns are configured as a basic pattern in the cross-shaped form to set up a channel of a DDR memory system, and another part of pinmap patterns are configured to include a pattern arranged in another form, to implement electrical connection with a corresponding external circuit, that is, the pinmap in the pin region of the package substrate may be obtained by combining several patterns.

Based on the first aspect, embodiments of this application further provide a first implementation of the first aspect: The fifth pin and the sixth pin are disposed on a perpendicular line of the connection line between the second pin and the third pin. Herein, the first direction is perpendicular to the second direction. Further, the fifth pin and the sixth pin may be disposed on a midperpendicular line of the connection line between the second pin and the third pin, so that overall structure symmetry is good, thereby obtaining a more compact overall layout in the pin region.

During actual application, a connection line between the fifth pin and the sixth pin may alternatively intersect with the connection line between the second pin and the third pin at another angle, which may also keep the data signal pins away from each other, thereby reducing the electromagnetic crosstalk.

Based on the first aspect or the first implementation of the first aspect, embodiments of this application further provide a second implementation of the first aspect: The basic pattern is of a centrosymmetric structure or an axisymmetric structure. In this way, the pin region may be fully utilized to implement high density, and a package size can be more appropriately controlled on the basis of effectively reducing the electromagnetic crosstalk between pins.

Based on the first aspect, or the first implementation of the first aspect, or the second implementation of the first aspect, embodiments of this application further provide a third implementation of the first aspect: The pins in the pin region of the package substrate are arranged in an array, and pins in rows and columns are staggered, that is, pins in each row and pins in each column are staggered. In this way, as many pins as possible may be arranged in a limited arrangement space, so that cross-shaped pinmap patterns can be densely and alternately arranged, and the pinmap density is further improved.

Based on the first aspect, or the first implementation of the first aspect, or the second implementation of the first aspect, embodiments of this application further provide a fourth implementation of the first aspect: The pins in the pin region of the package substrate are arranged in a triangular grid shape, and connection lines between the pin and two adjacent pins of the pin constitute an equilateral triangle. In this way, the cross-shaped pinmap patterns can be further densely and alternately arranged, and the pinmap density is further improved.

Based on the first aspect, or the first implementation of the first aspect, or the second implementation of the first aspect, or the third implementation of the first aspect, or the fourth implementation of the first aspect, embodiments of this application further provide a fifth implementation of the first aspect: The basic pattern further includes a ground pin. Herein, the ground pin is arranged at a periphery of the six signal pins. In this way, this ground pin arrangement can provide a low-impedance ground path, to form uniform ground potential, so that energy of an electromagnetic field is guided to a ground plane, thereby reducing the electromagnetic crosstalk between the signal pins, helping maintain signal integrity, and reducing noise.

For example, the ground pin may be of a solder ball structure, or may be of a metal contact structure.

Based on the fifth implementation of the first aspect, embodiments of this application further provide a sixth implementation of the first aspect: There are 14 ground pins in the basic pattern, the 14 ground pins are arranged at the periphery of the six signal pins and are sequentially spaced apart. Overall, the 14 ground pins are sequentially spaced apart to form a tetradecagon. Connection lines between the data signal pin adjacent to two adjacent ground pins and the two adjacent ground pins constitute an equilateral triangle. In this way, a space in the pin region in which the pins are staggered in rows and columns is fully utilized, a pinmap pattern is constructed according to an alternate pinmap rule, and a distance between any two adjacent pins is consistent. In addition to a return path function, the pinmap density can be improved, and a signal-to-ground ratio is high.

Based on the fifth implementation of the first aspect or the sixth implementation of the first aspect, embodiments of this application further provide a seventh implementation of the first aspect: Two basic patterns are adjacently disposed, one is a first basic pattern, the other is a second basic pattern, and adjacent sides of the first basic pattern and the second basic pattern share a ground pin. In other words, the two basic patterns share a ground pin on the adjacent side. In this way, in addition to effectively reducing the electromagnetic crosstalk, the pinmap density is more compact and appropriate.

During actual application, the pins in the pin region of the package substrate are staggered in rows and columns, pinmap combinations in different forms may be formed through concatenation after translation or rotation and translation. For example, a pinmap pattern in the cross-shaped form may correspondingly transmit data of a nibble, and a pinmap combination formed by concatenating two pinmap patterns may correspondingly transmit data of a byte.

For example, one of the two pinmap patterns of the pinmap combination may be a pattern formed by translating the other, or a pattern formed by rotating and translating the other.

Based on the seventh implementation of the first aspect, embodiments of this application further provide an eighth implementation of the first aspect: The first basic pattern and the second basic pattern are translated patterns of each other, the translation may be translation in the first direction, and the first basic pattern and the second basic pattern have a shared ground pin. A first pin, a second pin, a third pin, and a fourth pin of the first basic pattern are arranged in a same direction as a first pin, a second pin, a third pin, and a fourth pin of the second basic pattern. The shared ground pin is located between the fourth pin of the first basic pattern and the first pin of the second basic pattern.

Based on the seventh implementation of the first aspect, embodiments of this application further provide a ninth implementation of the first aspect: The first basic pattern and the second basic pattern are translated patterns of each other, and the translation may be translation in the second direction. A fifth pin and a sixth pin of the first basic pattern are arranged in a same direction as a fifth pin and a sixth pin of the second basic pattern. The first basic pattern and the second basic pattern have two shared ground pins that are spaced apart, and the two shared ground pins are located between the sixth pin of the first basic pattern and the fifth pin of the second basic pattern.

Based on the seventh implementation of the first aspect, embodiments of this application further provide a tenth implementation of the first aspect: The first basic pattern and the second basic pattern are translated patterns of each other, and the translation may be translation in a direction that separately forms an angle with the first direction and the second direction. A first pin, a second pin, a third pin, and a fourth pin of the first basic pattern are arranged in a same direction as a sixth pin of the second basic pattern. The first basic pattern and the second basic pattern have two shared ground pins that are spaced apart, and the two shared ground pins are located between the fourth pin of the first basic pattern and a first pin of the second basic pattern.

Based on the seventh implementation of the first aspect, embodiments of this application further provide an eleventh implementation of the first aspect: The first basic pattern and the second basic pattern are translated patterns of each other, and the translation may be translation in a direction that separately forms an angle with the first direction and the second direction. A fifth pin and a sixth pin of the first basic pattern are arranged in a same direction as a first pin of the second basic pattern. A fourth pin of the first basic pattern is arranged in a same direction as a fifth pin and a sixth pin of the second basic pattern. The first basic pattern and the second basic pattern have four shared ground pins. The four shared ground pins are sequentially spaced apart. Two shared ground pins are located between the sixth pin of the first basic pattern and the first pin of the second basic pattern, and the other two shared ground pins are located between the fourth pin of the first basic pattern and the fifth pin of the second basic pattern.

Based on the seventh implementation of the first aspect, embodiments of this application further provide a twelfth implementation of the first aspect: The first basic pattern and the second basic pattern are translated patterns of each other, and the translation may be translation in a direction that separately forms an angle with the first direction and the second direction. A fourth pin of the first basic pattern and a first pin of the second basic pattern are arranged in a same direction. A sixth pin of the first basic pattern and a fifth pin of the second basic pattern are arranged in a same direction. The first basic pattern and the second basic pattern have four shared ground pins. The four shared ground pins are sequentially spaced apart. Two shared ground pins are located between the fourth pin of the first basic pattern and the fifth pin of the second basic pattern, and the other two shared ground pins are located between the sixth pin of the first basic pattern and the first pin of the second basic pattern.

Based on the seventh implementation of the first aspect, embodiments of this application further provide a thirteenth implementation of the first aspect: The first basic pattern and the second basic pattern are translated and rotated patterns of each other. A first pin and a fifth pin of the first basic pattern are arranged in a same direction as a fifth pin and a sixth pin of the second basic pattern, and a sixth pin and a fourth pin of the first basic pattern are arranged in a same direction as a first pin of the second basic pattern. The first basic pattern and the second basic pattern have four shared ground pins. The four shared ground pins are sequentially spaced apart. Two shared ground pins are adjacent to the fifth pin of the first basic pattern, and the other two shared ground pins are adjacent to the fourth pin of the first basic pattern.

Based on the fifth implementation of the first aspect, embodiments of this application further provide a fourteenth implementation of the first aspect: There are 14 ground pins in the basic pattern, and the 14 ground pins are sequentially spaced apart at the periphery of the six signal pins. In addition, in the first direction, a first ground pin is located on a side of the first pin, and an eighth ground pin is located on a side of the fourth pin. Further, a second ground pin, a third ground pin, a fourth ground pin, a fifth ground pin, a sixth ground pin, and a seventh ground pin are sequentially arranged between the first ground pin and the eighth ground pin. A ninth ground pin, a tenth ground pin, an eleventh ground pin, a twelfth ground pin, a thirteenth ground pin, and a fourteenth ground pin are sequentially arranged between the eighth ground pin and the first ground pin. The overall layout is more compact and appropriate.

Based on the fourteenth implementation of the first aspect, embodiments of this application further provide a fifteenth implementation of the first aspect: Two basic patterns are adjacently disposed, one of the two basic patterns is a first basic pattern, the other of the two basic patterns is a second basic pattern, and adjacent sides of the first basic pattern and the second basic pattern share a ground pin.

Based on the fifteenth implementation of the first aspect, embodiments of this application further provide a sixteenth implementation of the first aspect: The first basic pattern and the second basic pattern are translated patterns of each other, and an eighth ground pin of the first basic pattern and a first ground pin of the second basic pattern are a shared ground pin.

Based on the fifteenth implementation of the first aspect, embodiments of this application further provide a seventeenth implementation of the first aspect: The first basic pattern and the second basic pattern are translated patterns of each other, a twelfth ground pin of the first basic pattern and a fourth ground pin of the second basic pattern are a shared ground pin, and an eleventh ground pin of the first basic pattern and a fifth ground pin of the second basic pattern are a shared ground pin.

Based on the fifteenth implementation of the first aspect, embodiments of this application further provide an eighteenth implementation of the first aspect: The first basic pattern and the second basic pattern are translated patterns of each other, a seventh ground pin of the first basic pattern and a first ground pin of the second basic pattern are a shared ground pin, and an eighth ground pin of the first basic pattern and a fourteenth ground pin of the second basic pattern are a shared ground pin.

Based on the fifteenth implementation of the first aspect, embodiments of this application further provide a nineteenth implementation of the first aspect: The first basic pattern and the second basic pattern are translated patterns of each other, a twelfth ground pin of the first basic pattern and a second ground pin of the second basic pattern are a shared ground pin, an eleventh ground pin of the first basic pattern and a third ground pin of the second basic pattern are a shared ground pin, a tenth ground pin of the first basic pattern and a fourth ground pin of the second basic pattern are a shared ground pin, and a ninth ground pin of the first basic pattern and a fifth ground pin of the second basic pattern are a shared ground pin.

Based on the fifteenth implementation of the first aspect, embodiments of this application further provide a twentieth implementation of the first aspect: The first basic pattern and the second basic pattern are translated patterns of each other, an eleventh ground pin of the first basic pattern and a first ground pin of the second basic pattern are a shared ground pin, a tenth ground pin of the first basic pattern and a second ground pin of the second basic pattern are a shared ground pin, a ninth ground pin of the first basic pattern and a third ground pin of the second basic pattern are a shared ground pin, and an eighth ground pin of the first basic pattern and a fourth ground pin of the second basic pattern are a shared ground pin.

Based on the fifteenth implementation of the first aspect, embodiments of this application further provide a twenty-first implementation of the first aspect: The first basic pattern and the second basic pattern are translated and rotated patterns of each other, a fifth ground pin of the first basic pattern and a fifth ground pin of the second basic pattern are a shared ground pin, a sixth ground pin of the first basic pattern and a fourth ground pin of the second basic pattern are a shared ground pin, a seventh ground pin of the first basic pattern and a third ground pin of the second basic pattern are a shared ground pin, and an eighth ground pin of the first basic pattern and a second ground pin of the second basic pattern are a shared ground pin.

Based on the first aspect, or the first implementation of the first aspect, or the second implementation of the first aspect, or the third implementation of the first aspect, or the fourth implementation of the first aspect, or the fifth implementation of the first aspect, or the sixth implementation of the first aspect, or the seventh implementation of the first aspect, or the eighth implementation of the first aspect, or the ninth implementation of the first aspect, or the tenth implementation of the first aspect, or the eleventh implementation of the first aspect, or the twelfth implementation of the first aspect, or the thirteenth implementation of the first aspect, or the fourteenth implementation of the first aspect, or the fifteenth implementation of the first aspect, or the sixteenth implementation of the first aspect, or the seventeenth implementation of the first aspect, or the eighteenth implementation of the first aspect, or the nineteenth implementation of the first aspect, or the twentieth implementation of the first aspect, or the twenty-first implementation of the first aspect, embodiments of this application further provide a twentysecond implementation of the first aspect: In the basic pattern including six signal pins, the first pin, the fourth pin, the fifth pin, and the sixth pin are single-ended signal pins for transmitting a DQ data signal; the second pin and the third pin in the six signal pins are differential signal pins for transmitting a DQS signal. In this way, when the two control signal pins transmit a DQS differential clock signal, polarities of a differential signal pair during transmission are opposite, that is, signal amplitudes transmitted on the two pins of the differential signal pair are opposite. Therefore, interference in two adjacent single-ended signal pins on an upper side and a lower side of the differential signal pins in the second direction can be fully canceled, and crosstalk of single-ended signal pins on a left side and a right side in the first direction can be partially canceled. This reduces total crosstalk of single-ended signals.

During actual application, for example, in an X8 scenario, the differential signal pins may be configured to reuse a channel for a DM signal, to transmit a DM signal, to mask and selectively write each data bit. When the control signal pins are for transmitting a DM signal, electromagnetic crosstalk that is actually generated is low, and data transmission of the data signal pins is not affected.

Based on the first aspect, embodiments of this application further provide a twentythird implementation of the first aspect: The chip may be a central processing unit, and the central processing unit is configured with a plurality of memory channels. Specifically, the memory channel includes a plurality of bytes, the byte corresponds to two of at least a part of basic patterns, and a data signal pin in the basic pattern is for transmitting a data signal of a corresponding byte. Therefore, based on effective reduction of electromagnetic crosstalk between pins, a higher data transmission speed and higher access efficiency can be obtained.

A second aspect of embodiments of this application provides an electronic device, including a housing and a circuit board disposed in the housing, where a chip is disposed on the circuit board. The chip is the chip described above, and a signal pin of the chip is electrically connected to the circuit board.

During actual application, the electronic device may be a computing device like a server, a super computer, or an Ethernet switch, or may be a terminal device like a mobile phone, a learning machine, or a notebook computer.

A third aspect of embodiments of this application provides a chip manufacturing method. In the manufacturing method, a die is disposed on a package substrate, and the die and the package substrate are assembled together to form this chip. Specifically, a plurality of pinmap patterns are disposed in a pin region of the package substrate, and at least two pinmap patterns in the plurality of pinmap patterns are basic patterns including six signal pins. A first pin, a second pin, a third pin, and a fourth pin in the six signal pins of the basic pattern are sequentially spaced apart in a first direction, a fifth pin and a sixth pin in the six signal pins are spaced apart in a second direction, the first direction is different from the second direction, and the fifth pin and the sixth pin are respectively located on two sides of a connection line between the second pin and the third pin. The first pin, the fourth pin, the fifth pin, and the sixth pin are data signal pins, the second pin and the third pin are control signal pins, and the method includes: transmitting a data signal through the first pin, the fourth pin, the fifth pin, and the sixth pin, and transmitting a control signal through the second pin and the third pin. The basic pattern arranged in the cross shape ensures correct signal transmission of the chip based on good anti-crosstalk performance, thereby providing technical assurance for high-performance and reliable system applications.

Based on the third aspect, embodiments of this application further provide a first implementation of the third aspect: The fifth pin and the sixth pin are disposed on a perpendicular line of the connection line between the second pin and the third pin. Herein, the first direction is perpendicular to the second direction.

Based on the first implementation of the third aspect, embodiments of this application further provide a second implementation of the third aspect: The fifth pin and the sixth pin are configured on a midperpendicular line of the connection line between the second pin and the third pin, and the basic pattern is of a centrosymmetric structure or an axisymmetric structure.

Based on the third aspect, the first implementation of the third aspect, or the second implementation of the third aspect, embodiments of this application further provide a third implementation of the third aspect: The pins in the pin region of the package substrate are arranged in a triangular grid shape, and specifically, connection lines between the pin and two adjacent pins of the pin constitute an equilateral triangle. In this way, the cross-shaped pinmap patterns can be further densely and alternately arranged, and the pinmap density is further improved.

Based on the third implementation of the third aspect, embodiments of this application further provide a fourth implementation of the third aspect: Two basic patterns are adjacently disposed, one of the two basic patterns is a first basic pattern, the other of the two basic patterns is a second basic pattern, and adjacent sides of the first basic pattern and the second basic pattern share a ground pin. In other words, the two basic patterns share a ground pin on the adjacent side. In this way, in addition to effectively reducing the electromagnetic crosstalk, the pinmap density is more compact and appropriate.

Based on the fourth implementation of the third aspect, embodiments of this application further provide a fifth implementation of the third aspect: The first basic pattern and the second basic pattern are translated patterns of each other, the translation may be translation in the first direction, and the first basic pattern and the second basic pattern have a shared ground pin. The shared ground pin is located between a fourth pin of the first basic pattern and a first pin of the second basic pattern.

Based on the fourth implementation of the third aspect, embodiments of this application further provide a sixth implementation of the third aspect: The first basic pattern and the second basic pattern are translated patterns of each other, and the translation may be translation in the second direction. The first basic pattern and the second basic pattern have two shared ground pins that are spaced apart, and the two shared ground pins are located between a sixth pin of the first basic pattern and a fifth pin of the second basic pattern.

Based on the fourth implementation of the third aspect, embodiments of this application further provide a seventh implementation of the third aspect: The first basic pattern and the second basic pattern are translated patterns of each other, and the translation may be translation in a direction that separately forms an angle with the first direction and the second direction. The first basic pattern and the second basic pattern have two shared ground pins that are spaced apart, and the two shared ground pins are located between a fourth pin of the first basic pattern and a first pin of the second basic pattern.

Based on the fourth implementation of the third aspect, embodiments of this application further provide an eighth implementation of the third aspect: The first basic pattern and the second basic pattern are translated patterns of each other, and the translation may be translation in a direction that separately forms an angle with the first direction and the second direction. The first basic pattern and the second basic pattern have four shared ground pins. The four shared ground pins are sequentially spaced apart. Two shared ground pins are located between a sixth pin of the first basic pattern and a first pin of the second basic pattern, and the other two shared ground pins are located between a fourth pin of the first basic pattern and a fifth pin of the second basic pattern.

Based on the fourth implementation of the third aspect, embodiments of this application further provide a ninth implementation of the third aspect: The first basic pattern and the second basic pattern are translated patterns of each other, and the translation may be translation in a direction that separately forms an angle with the first direction and the second direction. The first basic pattern and the second basic pattern have four shared ground pins. The four shared ground pins are sequentially spaced apart. Two shared ground pins are located between a fourth pin of the first basic pattern and a fifth pin of the second basic pattern, and the other two shared ground pins are located between a sixth pin of the first basic pattern and a first pin of the second basic pattern.

Based on the fourth implementation of the third aspect, embodiments of this application further provide a tenth implementation of the third aspect: The first basic pattern and the second basic pattern are translated and rotated patterns of each other. The first basic pattern and the second basic pattern have four shared ground pins. The four shared ground pins are sequentially spaced apart. Two shared ground pins are adjacent to a fifth pin of the first basic pattern, and the other two shared ground pins are adjacent to a fourth pin of the first basic pattern.

A fourth aspect of embodiments of this application provides a signal transmission method. The signal transmission method is applied to a chip. Specifically, the chip includes a package substrate. A plurality of pinmap patterns are disposed in a pin region of the package substrate, and at least two pinmap patterns in the plurality of pinmap patterns are basic patterns including six signal pins. A first pin, a second pin, a third pin, and a fourth pin in the six signal pins of the basic pattern are sequentially spaced apart in a first direction, a fifth pin and a sixth pin in the six signal pins are spaced apart in a second direction, the first direction is different from the second direction, and the fifth pin and the sixth pin are respectively located on two sides of a connection line between the second pin and the third pin. The first pin, the fourth pin, the fifth pin, and the sixth pin are data signal pins, the second pin and the third pin are control signal pins, and the method includes: transmitting a data signal through the first pin, the fourth pin, the fifth pin, and the sixth pin, and transmitting a control signal through the second pin and the third pin. The basic pattern arranged in the cross shape ensures correct signal transmission of the chip based on good anti-crosstalk performance, thereby providing technical assurance for high-performance and reliable system applications.

Based on the fourth aspect, embodiments of this application further provide a first implementation of the fourth aspect: The fifth pin and the sixth pin are disposed on a perpendicular line of the connection line between the second pin and the third pin. Herein, the first direction is perpendicular to the second direction.

Based on the first implementation of the fourth aspect, embodiments of this application further provide a second implementation of the fourth aspect: The fifth pin and the sixth pin are configured on a midperpendicular line of the connection line between the second pin and the third pin, and the basic pattern is of a centrosymmetric structure or an axisymmetric structure.

Based on the fourth aspect, the first implementation of the fourth aspect, or the second implementation of the fourth aspect, embodiments of this application further provide a third implementation of the fourth aspect: The pins in the pin region of the package substrate are arranged in a triangular grid shape, and specifically, connection lines between the pin and two adjacent pins of the pin constitute an equilateral triangle. In this way, the cross-shaped pinmap patterns can be further densely and alternately arranged, and the pinmap density is further improved.

Based on the third implementation of the fourth aspect, embodiments of this application further provide a fourth implementation of the fourth aspect: Two basic patterns are adjacently disposed, one of the two basic patterns is a first basic pattern, the other of the two basic patterns is a second basic pattern, and adjacent sides of the first basic pattern and the second basic pattern share a ground pin. In other words, the two basic patterns share a ground pin on the adjacent side. In this way, in addition to effectively reducing the electromagnetic crosstalk, the pinmap density is more compact and appropriate.

Based on the fourth implementation of the fourth aspect, embodiments of this application further provide a fifth implementation of the fourth aspect: The first basic pattern and the second basic pattern are translated patterns of each other, the translation may be translation in the first direction, and the first basic pattern and the second basic pattern have a shared ground pin. The shared ground pin is located between a fourth pin of the first basic pattern and a first pin of the second basic pattern.

Based on the fourth implementation of the fourth aspect, embodiments of this application further provide a sixth implementation of the fourth aspect: The first basic pattern and the second basic pattern are translated patterns of each other, and the translation may be translation in the second direction. The first basic pattern and the second basic pattern have two shared ground pins that are spaced apart, and the two shared ground pins are located between a sixth pin of the first basic pattern and a fifth pin of the second basic pattern.

Based on the fourth implementation of the fourth aspect, embodiments of this application further provide a seventh implementation of the fourth aspect: The first basic pattern and the second basic pattern are translated patterns of each other, and the translation may be translation in a direction that separately forms an angle with the first direction and the second direction. The first basic pattern and the second basic pattern have two shared ground pins that are spaced apart, and the two shared ground pins are located between a fourth pin of the first basic pattern and a first pin of the second basic pattern.

Based on the fourth implementation of the fourth aspect, embodiments of this application further provide an eighth implementation of the fourth aspect: The first basic pattern and the second basic pattern are translated patterns of each other, and the translation may be translation in a direction that separately forms an angle with the first direction and the second direction. The first basic pattern and the second basic pattern have four shared ground pins. The four shared ground pins are sequentially spaced apart. Two shared ground pins are located between a sixth pin of the first basic pattern and a first pin of the second basic pattern, and the other two shared ground pins are located between a fourth pin of the first basic pattern and a fifth pin of the second basic pattern.

Based on the fourth implementation of the fourth aspect, embodiments of this application further provide a ninth implementation of the fourth aspect: The first basic pattern and the second basic pattern are translated patterns of each other, and the translation may be translation in a direction that separately forms an angle with the first direction and the second direction. The first basic pattern and the second basic pattern have four shared ground pins. The four shared ground pins are sequentially spaced apart. Two shared ground pins are located between a fourth pin of the first basic pattern and a fifth pin of the second basic pattern, and the other two shared ground pins are located between a sixth pin of the first basic pattern and a first pin of the second basic pattern.

Based on the fourth implementation of the fourth aspect, embodiments of this application further provide a tenth implementation of the fourth aspect: The first basic pattern and the second basic pattern are translated and rotated patterns of each other. The first basic pattern and the second basic pattern have four shared ground pins. The four shared ground pins are sequentially spaced apart. Two shared ground pins are adjacent to a fifth pin of the first basic pattern, and the other two shared ground pins are adjacent to a fourth pin of the first basic pattern.

A fifth aspect of embodiments of this application provides a method for reading/sending data by a CPU. The CPU includes a package substrate. A pin region of the package substrate includes a data signal pin and a data strobe signal pin, and the data signal pin and the data strobe signal pin are arranged according to a pinmap pattern. The pinmap pattern includes six signal pins. A first pin, a fourth pin, a fifth pin, and a sixth pin in the six signal pins are data signal pins, and a second pin and a third pin in the six signal pins are data strobe signal pins. The first pin, the second pin, the third pin, and the fourth pin are sequentially spaced apart in a first direction, and the fifth pin and the sixth pin are spaced apart in a second direction. The fifth pin and the sixth pin are configured on a perpendicular line of a connection line between the second pin and the third pin, and are respectively located on two sides of the second pin and the third pin. The method for reading/sending data by the CPU includes: responding to a write instruction or a read instruction of a DDR signal; and sending the data to a DDR memory according to the write instruction through the data signal pin, and outputting a data strobe signal through the data strobe signal pin; or receiving the data from a DDR memory according to the read instruction through the data signal pin, and reading a data strobe signal through the data strobe signal pin.

A sixth aspect of embodiments of this application provides a method for reading data by a CPU. The CPU includes a package substrate. A pin region of the package substrate includes a data signal pin and a data strobe signal pin, and the data signal pin and the data strobe signal pin are arranged according to a pinmap pattern. The pinmap pattern includes six signal pins. A first pin, a fourth pin, a fifth pin, and a sixth pin in the six signal pins are data signal pins, and a second pin and a third pin in the six signal pins are data strobe signal pins. The first pin, the second pin, the third pin, and the fourth pin are sequentially spaced apart in a first direction, and the fifth pin and the sixth pin are spaced apart in a second direction. The fifth pin and the sixth pin are configured on a perpendicular line of a connection line between the second pin and the third pin, and are respectively located on two sides of the second pin and the third pin. The method for reading data by the CPU includes: responding to a write instruction of a DDR signal, where in a specific implementation, when the CPU or another device needs to read the data in a memory, a memory controller sends a read command to a memory module, and specifies an address from which the data is read; and sending the data to a DDR memory according to the write instruction through the data signal pin, and outputting a data strobe signal through the data strobe signal pin, that is, providing a data clock signal to the DDR memory, so that the DDR memory correctly receives and parses the data sent by the CPU.

A seventh aspect of embodiments of this application provides a method for sending data by a CPU. The CPU includes a package substrate. A pin region of the package substrate includes a data signal pin and a data strobe signal pin, and the data signal pin and the data strobe signal pin are arranged according to a pinmap pattern. The pinmap pattern includes six signal pins. A first pin, a fourth pin, a fifth pin, and a sixth pin in the six signal pins are data signal pins, and a second pin and a third pin in the six signal pins are data strobe signal pins. The first pin, the second pin, the third pin, and the fourth pin are sequentially spaced apart in a first direction, and the fifth pin and the sixth pin are spaced apart in a second direction. The fifth pin and the sixth pin are configured on a perpendicular line of a connection line between the second pin and the third pin, and are respectively located on two sides of the second pin and the third pin. The method for reading/sending data by the CPU includes: responding to a read instruction of a DDR signal, where in a specific implementation, when the CPU or another device needs to write the data into a memory, a memory controller sends a write command to a memory module, and provides a to-be-written data and a target address; and receiving the data from a DDR memory according to the read instruction through the data signal pin, and reading a data strobe signal through the data strobe signal pin, that is, providing a data clock signal for the CPU, so that the CPU correctly samples and parses the data transmitted from the DDR memory.

### BRIEF DESCRIPTION OF DRAWINGS

FIG. 1 is a diagram of a partial structure of an electronic device according to an embodiment of this application;
FIG. 2 is a diagram of a pinmap of a package substrate according to an embodiment of this application;
FIG. 3 is a diagram of a structure of a pinmap in a pin region of a package substrate according to an embodiment of this application;
FIG. 4 is a diagram of a construction relationship of a basic pattern according to an embodiment of this application;
FIG. 5 is a diagram of a basic pattern combination manner according to an embodiment of this application;
FIG. 6 to FIG. 10 are respectively diagrams of another five basic pattern combination manners according to an embodiment of this application;
FIG. 11 is a diagram of a hardware architecture of a CPU DDR interface according to an embodiment of this application;
FIG. 12 is a diagram of a relationship between a CPU DDR interface and a basic pattern according to an embodiment of this application;
FIG. 13 is a diagram of another two manners of combining a plurality of basic patterns according to an embodiment of this application;
FIG. 14 is a schematic flowchart of a method for reading/sending data by a CPU according to an embodiment of this application;
FIG. 15 is a diagram of a pin configuration in a CPU application scenario according to an embodiment of this application;
FIG. 16 is a diagram of a pin configuration in another CPU application scenario according to an embodiment of this application;
FIG. 17 is a diagram of a pin configuration in still another CPU application scenario according to an embodiment of this application; and
FIG. 18 is a diagram of an architecture of an electronic device according to an embodiment of this application.

### DESCRIPTION OF EMBODIMENTS

Embodiments of this application provide a package substrate pinmap solution of a chip, to effectively reduce crosstalk between pins on the basis of appropriately controlling a package size by increasing pinmap density.

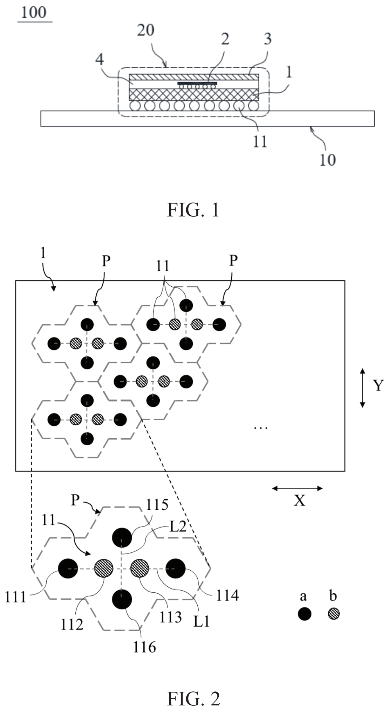

FIG. 1 is a diagram of a partial structure of an electronic device according to an embodiment of this application. The electronic device 100 includes a circuit board 10 and a chip 20 disposed on the circuit board 10. In a specific implementation, the electronic device may be a device like a communication terminal device, a server, a super computer, a router, or a switch.

The chip 20 may include a package substrate 1 and a die 2. The package substrate 1 is a carrier for packaging the die 2, and packaging is implemented by using a housing 3. Herein, the die (Chip) is a bare die (Die) that is formed by processing and cutting a wafer. The package substrate (Package substrate) is a carrier for packaging a semiconductor chip. External pins of a semiconductor package are formed on the package substrate. Current development directions of the package substrate are to implement multiple pins, reduce a size of a package product, implement a high-density design of package pins, and improve electrical performance of a physical interface.

During semiconductor die packaging, the die 2 may be placed on the package substrate 1, and an upper surface of the package substrate 1 is a region for disposing the die. Specifically, in a manufacturing process of the chip 20, the die may be packaged by using a packaging process to assemble and form a semiconductor package (Package), that is, a chip product, to provide functions such as protection, heat management, mechanical support, and electrical connection.

Specifically, when the semiconductor package is manufactured, the die is usually disposed on the package substrate, and a pin of the die is electrically connected to a solder ball or a pad of the package substrate through gold wire bonding, chip flipping, or tape-automated bonding; and then the die and the package substrate are packaged to form a semiconductor package, that is, a different chip product. The external pins of the chip may be electrically connected to a PCB, so that the die is connected to an external circuit, and the die may further be electrically connected to another component through PCB wiring.

As shown in FIG. 1, the pins on the die 2 are connected to the solder ball or pad of the package substrate 1 by using a die flipping technology. In another specific implementation, the pins on the die 2 may be further connected to a solder ball or a pad of the package substrate 1 by using a gold wire bonding technology. This is not limited in this embodiment of this application.

A package filler 4 may be further disposed between the package substrate 1 and the housing 3. The package filler 4 may be used to wrap the die 2, to reduce adverse impacts of external dust, impurities, and the like on performance of the die 2. In addition, components such as the package substrate 1, the housing 3, and the die 2 may be further integrally coupled, to improve structural strength of the chip 20.

The external pins of the chip 20 are located on the package substrate 1, and a lower surface of the package substrate 1 is a pin region. Correspondingly, a pin interface configured to connect to the chip 20 may be disposed on the circuit board 10. Signal pins 11 on the package substrate 1 may be of a solder ball structure shown in the figure, and is electrically connected to a corresponding pad on the circuit board 10 through welding, and the die 2 is connected to another component through a conducting wire on the circuit board 10, to implement connection between the die 2 and the external circuit.

It may be understood that the signal pins is used to establish pins for signal transmission and data exchange between chips. The signal pins include data signal pins and control signal pins, and may be applied to different parallel bus transmission modes, to transmit a large amount of data and control signals. The data signal pin is configured to transmit a DQ (Data Input/Output, data input/output) signal, to transmit data bit or byte information. The control signal pin may transmit a corresponding control signal according to different application scenarios, for example, but not limited to, according to a DDR bus protocol, the control signal pin may be configured to transmit a DQS (Data Strobe, data strobe) signal to indicate a data sampling moment; and the control signal pin may be further configured to transmit a DM (Input Data Mask, input data mask) signal to indicate validity of each data signal bit (DQ), to implement masking and selective writing of each data bit; or according to a flash (flash) ONFI (open NAND flash interface) bus protocol, the control signal pin is configured to transmit a signal for controlling data transmission, to perform data transmission and communication between a flash memory controller and a flash memory chip.

In a specific implementation, the signal pin on the chip 20 may alternatively be a metal contact located on the package substrate 1. A metal spring is correspondingly disposed on the circuit board 10, and metal contacts on the chip 20 side and metal springs on the circuit board 10 side (not shown in the figure) are disposed in a one-to-one correspondence manner. After the chip 20 is fastened to an installation position on the circuit board 10, the metal contact presses against the metal spring, and reliable contact with the adapted metal contact is maintained through the deformed metal spring to implement electrical connection of the corresponding pin. It may be understood that a specific connection structure between the external pin of the chip 20 and the circuit board 10 may be configured based on an actual application scenario. This is not limited in this embodiment of this application.

Generally, an important indicator for measuring performance of a chip packaging technology is a ratio of a chip area (a die area) to a package area. When an area of the die 2 is fixed, a smaller ratio indicates a larger package area, that is, a larger size of the chip 20 reduces a manufacturing yield of the chip 20 and increases manufacturing costs. A ratio closer to 1 indicates a smaller package area, an increase in the manufacturing yield of the chip 20, and a corresponding reduction in manufacturing costs. For the package substrate 1, pinmap density of the package substrate 1 is an important factor that affects the package area. However, an increase of the pinmap density of the package substrate 1 causes electromagnetic crosstalk between the pins, affecting performance of the chip product.

In addition, to reduce the electromagnetic crosstalk between the pins, a ground pin is disposed around the pins of the package substrate of the chip, and the ground pin is used for grounding connection. Specifically, in the pinmap (Pinmap) of the chip, this ground pin arrangement can provide a low-impedance ground path, to form uniform ground potential, so that energy of an electromagnetic field is guided to a ground plane, thereby reducing the electromagnetic crosstalk (also referred to as mutual interference) between the signal pins, maintaining signal integrity, and reducing noise. However, this ground pin arrangement increases the size of the chip. Therefore, the pinmap density needs to be further improved to reduce the package area.

Based on this, an embodiment of this application provides a Pinmap pinmap solution. FIG. 2 is a diagram of a pinmap of a package substrate according to an embodiment of this application. For ease of description, two pinmap directions in a pin region of the package substrate 1 are defined in this specification. A first direction X is a left-right pinmap direction of pins shown in the figure, and a second direction Y is a top-down pinmap direction of the pins shown in the figure. It should be understood that use of the foregoing orientation words does not constitute a substantive limitation on the technical solutions described in this application.

A plurality of pinmap patterns (Pinmap Patterns) are disposed in the pin region on a body of the package substrate 1. As shown in FIG. 2, the pinmap pattern is a basic pattern P including six signal pins 11. A first pin 111, a second pin 112, a third pin 113, and a fourth pin 114 in the six signal pins 11 are sequentially spaced apart in a first direction X, and a fifth pin 115 and a sixth pin 116 in the six signal pins are spaced apart in a second direction Y. The fifth pin 115 and the sixth pin 116 are disposed on a midperpendicular line L2 of a connection line L1 between the second pin 112 and the third pin 113, and are respectively located on two sides of the connection line L1 of the second pin 112 and the third pin 113. The first pin 111, the fourth pin 114, the fifth pin 115, and the sixth pin 116 are data signal pins a (solid filled pins in the figure), and the second pin 112 and the third pin 113 are control signal pins b (pins filled with slashes in the figure).

Overall, the pinmap pattern is a pattern of which pins are arranged in a cross shape. The four data signal pins a are respectively arranged at four extension ends of the cross-shaped pattern, and the control signal pins b are arranged in the middle of the cross-shaped pattern. In this way, the data signal pins a are far away from each other, and each data signal pin a has no adjacent data signal pin a that may form a crosstalk source, thereby effectively avoiding an impact of electromagnetic crosstalk between adjacent data signal pins a. This pinmap solution effectively reduces the electromagnetic crosstalk between pins, and supports a higher running rate of a parallel bus, for example, but not limited to, a DDR bus or a flash ONFI bus, to transmit data and a control signal at a high speed. In addition, this pinmap solution can improve pinmap density and reduce a package area, thereby providing technical assurance for further improving a product yield and reducing processing costs.

Herein, in FIG. 2 and the following accompanying drawings, dashed lines connecting the signal pins 11 merely indicate a position relationship of the pins, and a dashed line surrounding a periphery of the signal pins 11 merely indicates a pinmap region of the basic pattern P. Corresponding dashed lines do not exist in a structure of the package substrate, and do not constitute a limitation on a specific structure of the package substrate.

In another specific implementation, the plurality of pinmap patterns in the pin region of the package substrate 1 may be configured as pinmaps in different forms based on actual function requirements. For example, a part of a plurality of pinmap patterns in a pin region of a CPU chip may be basic patterns P, and configured as patterns arranged in a cross shape shown in the figure, to establish a parallel bus channel. The other part of the pinmap patterns are configured to include a pattern arranged in another form (not shown in the figure), to implement electrical connection to a corresponding external circuit, that is, a pinmap in the pin region of the package substrate 1 may be obtained by combining and arranging several patterns, instead of being limited to a case in which all patterns shown in FIG. 2 are configured as pinmap patterns arranged in a cross shape.

In this implementation solution, the fifth pin 115 and the sixth pin 116 are configured on the midperpendicular line of the connection line between the second pin 112 and the third pin 113, that is, a distance between the second pin 112 and a connection line between the fifth pin 115 and the sixth pin 116 and a distance between the third pin 113 and the connection line between the fifth pin 115 and the sixth pin 116 are equal, and the pattern arranged in the cross shape is of a centrosymmetric structure.

In a specific implementation, the distance between the second pin 112 and the connection line between the fifth pin 115 and the sixth pin 116 and the distance between the third pin 113 and the connection line between the fifth pin 115 and the sixth pin 116 may be unequal (not shown in the figure). In other words, the fifth pin 115 and the sixth pin 116 are located on two sides of the connection line between the second pin 112 and the third pin 113. In this way, an implementation solution in which no adjacent crosstalk source is formed for any data signal pin can also be implemented. In addition, in another specific implementation, the connection line between the fifth pin 115 and the sixth pin 116 may alternatively intersect with the connection line between the second pin 112 and the third pin 113 at another angle (not shown in the figure).

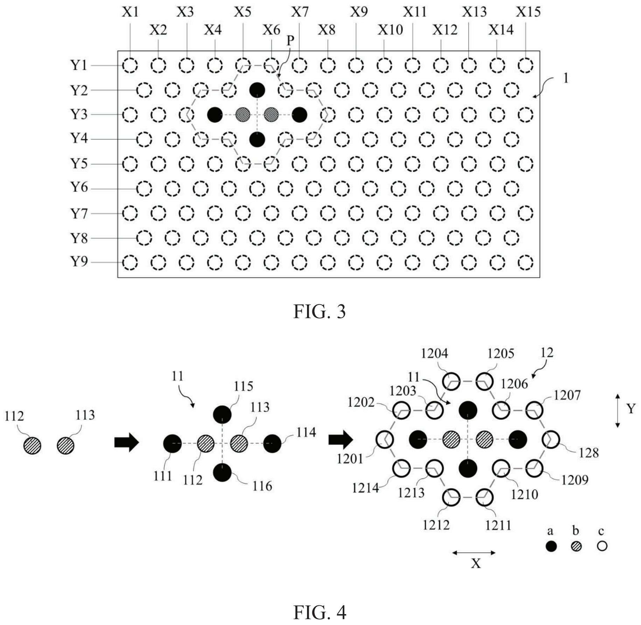

In contrast, in an implementation in which the fifth pin 115 and the sixth pin 116 are configured on the midperpendicular line of the connection line between the second pin 112 and the third pin 113, the pinmap density of the pin region can be maximized on the basis of effectively reducing the impact of the electromagnetic crosstalk. FIG. 3 is a diagram of a structure of a pinmap in a pin region of a package substrate according to an embodiment of this application. With reference to FIG. 3, pins in the pin region of the package substrate 1 are arranged in an array, and pins in rows and columns are staggered. That the pins in rows and columns are staggered means that pins in each row (X1 to X15) and pins in each column (Y1 to Y9) are staggered. In this way, as many pins as possible may be arranged in a limited arrangement space. In other words, the pins in the pin region are arranged in a triangular grid shape, and connection lines between each pin and two adjacent pins of the pin constitute an equilateral triangle. In this way, cross-shaped pinmap patterns can be densely and alternately arranged, and pinmap density is further improved.

It should be noted that, for each pin in the pin region of the package substrate 1, the pin and other two adjacent pins of the pin are arranged in an equilateral triangle, including an equilateral triangle arrangement relationship with good shape and position tolerance control, and further including a triangle arrangement relationship with dimension tolerance affected by processing process precision, that is, further including a case in which a specific deviation exists within a range limited by process precision, and the arrangement is not fully but roughly in an equilateral triangle.

Further, a ground (GND) pin may be disposed at a periphery of the six signal pins 11 of the cross-shaped pattern. FIG. 4 is a diagram of a construction relationship of a basic pattern according to an embodiment of this application.

As shown in the figure, for six signal pins 11 corresponding to the cross-shaped pattern, 14 ground pins 12 (pins c shown as single-lined circles in the figure) are disposed in the basic pattern P. Two control signal pins b are used as a center, and four data signal pins a are respectively disposed at the most adjacent positions on an upper side, a lower side, a left side, and a right side of the two control signal pins b. Finally, the ground pins c are disposed at a periphery, to form a return path around each signal pin 11, thereby reducing electromagnetic interference between the pin and another pin.

The 14 ground pins 12 described in FIG. 4 surround the periphery of the six signal pins 11, and the 14 ground pins 12 are sequentially spaced apart to form a tetradecagon. In a first direction X, a first ground pin 1201 is located on a side of a first pin 111, an eighth ground pin 1208 is located on a side of a fourth pin 114, and a second ground pin 1202, a third ground pin 1203, a fourth ground pin 1204, a fifth ground pin 1205, a sixth ground pin 1206, and a seventh ground pin 1207 are sequentially arranged between the first ground pin 1201 and the eighth ground pin 1208. A ninth ground pin 1209, a tenth ground pin 1210, an eleventh ground pin 1211, a twelfth ground pin 1212, a thirteenth ground pin 1213, and a fourteenth ground pin 1214 are sequentially arranged between the eighth ground pin 1208 and the first ground pin 1201.

Connection lines between a data signal pin a adjacent to two adjacent ground pins 12 and the two adjacent ground pins 12 constitute an equilateral triangle S. Each data signal pin a is located on a midperpendicular line of a connection line between the two adjacent ground pins 12 of the data signal pin a. To simplify the diagram, only the first pin 111 is used as an example in the figure to show a relative location relationship between the first pin 111 and two adjacent ground pins 12. In this way, a space in a pin region in which all pins in rows and columns are staggered is fully utilized, a pinmap pattern is constructed according to an alternate pinmap rule, and a distance between any two adjacent pins is consistent. In addition to a return path function, the pinmap density can be improved, and a signal-to-ground ratio is high. The "signal-to-ground ratio" herein refers to a ratio of a quantity of signal pins 11 to a quantity of ground pins 12 in a unit area. It may be understood that, in another specific implementation, the quantity of ground pins 12 may be determined based on a requirement. This is not limited in this embodiment of this application.

In a specific implementation, one basic pattern P may correspond to one Nibble (nibble) signal pin, and data of each Nibble may be transmitted by using four DQ data signals and a pair of DQS differential clock signals. The four data signal pins a in the six signal pins 11 are single-ended signal pins for transmitting a DQ data signal. The two control signal pins b in the six signal pins 11 are differential signal pins for transmitting a DQS signal.

When the two control signal pins (the second pin 112 and the third pin 113) transmit a DQS differential clock signal, polarities of a differential signal pair during transmission are opposite, that is, signal amplitudes transmitted on the two pins of the differential signal pair are opposite. In this way, interference in two adjacent single-ended signal pins (a fifth pin 115 and a sixth pin 116) on an upper side and a lower side in a second direction Y can be fully canceled, and crosstalk on two single-ended signal pins (the first pin 111 and the fourth pin 114) on a left side and a right side in the first direction X can be partially canceled, thereby reducing a total amount of crosstalk on the single-ended signals.

In a scenario of a DDR system, a data signal of the DDR system is usually divided by byte (byte) based on a definition of a DDR signal, and each byte uses four DQ data signals and a pair of DQS differential clock signals for transmission. Based on the basic pattern P, data of one byte may be transmitted by using a combination formed by two basic patterns P, that is, in a DDR pinmap design, a byte is usually used as a basic unit for a pinmap.

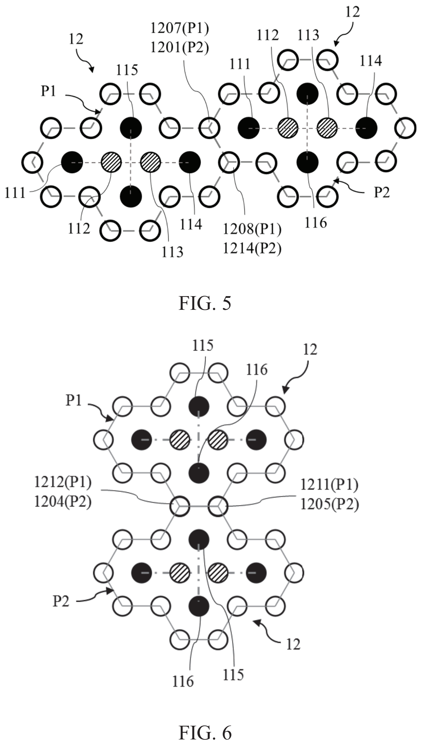

FIG. 5 is a diagram of a basic pattern P combination manner according to an embodiment of this application. The figure shows a combination formed by concatenating two basic patterns P. In this way, data of one byte can be transmitted. The combination is formed by concatenating two basic patterns P based on the basic pattern P described in FIG. 4, to constitute a pinmap combination corresponding to one byte, that is, adjacent sides of a first basic pattern P1 and a second basic pattern P2 share a ground pin.

As shown in FIG. 5, the first basic pattern P1 and the second basic pattern P2 are translated patterns of each other, that is, one of the two basic patterns P is a pattern formed by translating the other. A fifth pin 115 of the first basic pattern P1 is arranged in a same direction as a first pin 111, a second pin 112, a third pin 113, and a fourth pin 114 of the second basic pattern P2. A first pin 111, a second pin 112, a third pin 113, and a fourth pin 114 of the first basic pattern P1 are arranged in a same direction as a sixth pin 116 of the second basic pattern P2.

In this implementation, the first basic pattern P1 and the second basic pattern P2 share two ground pins 12, and the two shared ground pins 12 are located between the fourth pin 114 of the first basic pattern P1 and the first pin 111 of the second basic pattern P2. Specifically, a seventh ground pin 1207 of the first basic pattern P1 and a first ground pin 1201 of the second basic pattern P2 are a shared ground pin, and an eighth ground pin 1208 of the first basic pattern P1 and a fourteenth ground pin 1214 of the second basic pattern P2 are a shared ground pin. In this way, in addition to effectively reducing the electromagnetic crosstalk, the pinmap density is more compact and appropriate.

In a specific implementation, eight data signal pins a of the two basic patterns P may correspond to eight data pins on a data bus: a DQ 0, a DQ 1, a DQ 2, a DQ 3, a DQ 4, a DQ 5, a DQ 6, and a DQ 7, for respectively sending or receiving data of a data bit 0 to a data bit 7. Four control signal pins of the two basic patterns P correspond to four data clock signal pins on the data bus: a DQS 0, a DQS 1, a DQS 2, and a DQS 3. The DQS 0 and the DQS 1 are a pair of differential signal pins, and the DQS 2 and the DQS 3 are a pair of differential pair pins, which are respectively used to perform timing and synchronization on data during data transmission.

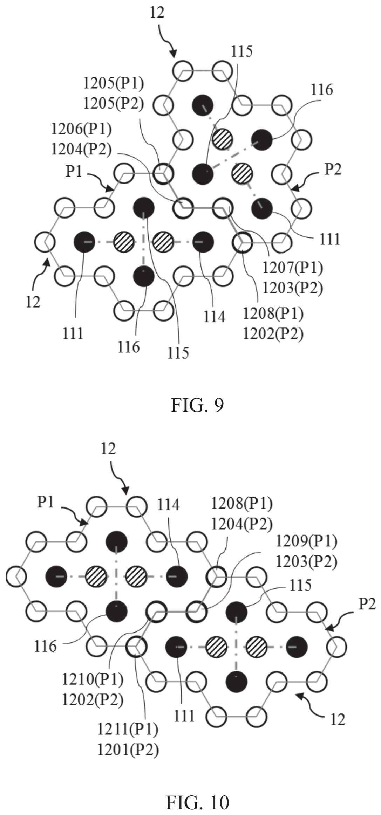

Pins in rows and columns in the pin region of the package substrate 1 are staggered, pinmap combinations in different forms may be formed through concatenation after translation or rotation and translation. Refer to FIG. 6 to FIG. 10. Five different basic pattern combination manners are respectively shown. For combinations shown in FIG. 6, FIG. 7, FIG. 8, and FIG. 10, one of two basic patterns P is a pattern formed by translating the other. For a combination shown in FIG. 9, one of two basic patterns P is a pattern formed by rotating and translating the other.

As shown in FIG. 6, a first basic pattern P1 and a second basic pattern P2 are translated patterns of each other. A fifth pin 115 and a sixth pin 116 of the first basic pattern P1 are arranged in a same direction as a fifth pin 115 and a sixth pin 116 of the second basic pattern P2.

In this implementation, the two basic patterns share two ground pins 12 that are spaced apart, and the two shared ground pins 12 are located between the sixth pin 116 of the first basic pattern P1 and the fifth pin 115 of the second basic pattern P2. Specifically, a twelfth ground pin 1212 of the first basic pattern P1 and a fourth ground pin 1204 of the second basic pattern P2 are a shared ground pin, and an eleventh ground pin 1211 of the first basic pattern P1 and a fifth ground pin 1205 of the second basic pattern P2 are a shared ground pin.

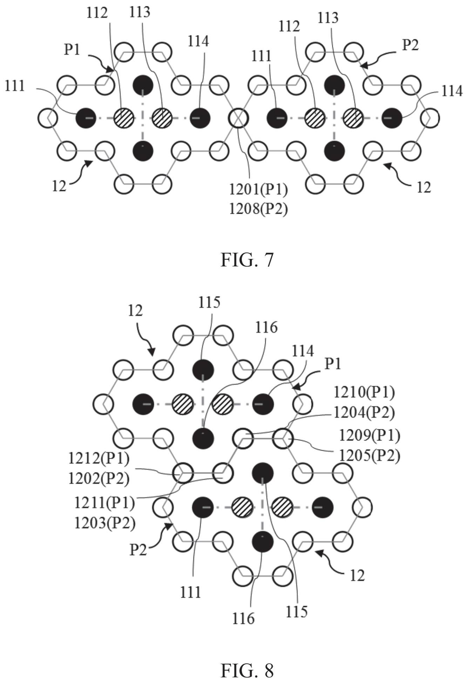

As shown in FIG. 7, a first basic pattern P1 and a second basic pattern P2 are translated patterns of each other. A first pin 111, a second pin 112, a third pin 113, and a fourth pin 114 of the first basic pattern P1 are arranged in a same direction as a first pin 111, a second pin 112, a third pin 113, and a fourth pin 114 of the second basic pattern P2.

In this implementation, the two basic patterns share one ground pin 12, and the shared ground pin 12 is located between the fourth pin 114 of the first basic pattern P1 and the first pin 111 of the second basic pattern P2. Specifically, an eighth ground pin 1208 of the first basic pattern P1 and a first ground pin 1201 of the second basic pattern P2 are a shared ground pin.

As shown in FIG. 8, a first basic pattern P1 and a second basic pattern P2 are translated patterns of each other. A fifth pin 115 and a sixth pin 116 of the first basic pattern P1 are arranged in a same direction as a first pin 111 of the second basic pattern P2. A fourth pin 114 of the first basic pattern P1 is arranged in a same direction as a fifth pin 115 and a sixth pin 116 of the second basic pattern P2.

In this implementation, the two basic patterns share four ground pins 12 that are sequentially spaced apart. Two shared ground pins 12 are located between the sixth pin 116 of the first basic pattern P1 and the first pin 111 of the second basic pattern P2, and the other two shared ground pins 12 are located between the fourth pin 114 of the first basic pattern P1 and the fifth pin 115 of the second basic pattern P2. Specifically, a twelfth ground pin 1212 of the first basic pattern P1 and a second ground pin 1202 of the second basic pattern P2 are a shared ground pin, an eleventh ground pin 1211 of the first basic pattern P1 and a third ground pin 1203 of the second basic pattern P2 are a shared ground pin, a tenth ground pin 1210 of the first basic pattern P1 and a fourth ground pin 1204 of the second basic pattern P2 are a shared ground pin, and a ninth ground pin 1209 of the first basic pattern P1 and a fifth ground pin 1205 of the second basic pattern P2 are a shared ground pin.

As shown in FIG. 9, a first basic pattern P1 and a second basic pattern P2 are translated and rotated patterns of each other. A first pin 111 and a fifth pin 115 of the first basic pattern P1 are arranged in a same direction as a fifth pin 115 and a sixth pin 116 of the second basic pattern P2. A sixth pin 116 and a fourth pin 114 of the first basic pattern P1 are arranged in a same direction as a first pin 111 of the second basic pattern P2.

In this implementation, the two basic patterns share four ground pins 12 that are sequentially spaced apart. Two shared ground pins 12 are located between the fifth pin 115 of the first basic pattern P1 and the fifth pin 115 of the second basic pattern P2, and the other two shared ground pins 12 are located between the fourth pin 114 of the first basic pattern P1 and the first pin 111 of the second basic pattern P2. Specifically, a fifth ground pin 1205 of the first basic pattern P1 and a fifth ground pin 1205 of the second basic pattern P2 are a shared ground pin, a sixth ground pin 1206 of the first basic pattern P1 and a fourth ground pin 1204 of the second basic pattern P2 are a shared ground pin, a seventh ground pin 1207 of the first basic pattern P1 and a third ground pin 1203 of the second basic pattern P2 are a shared ground pin, and an eighth ground pin 1208 of the first basic pattern P1 and a second ground pin 1202 of the second basic pattern P2 are a shared ground pin.

As shown in FIG. 10, a first basic pattern P1 and a second basic pattern P2 are translated patterns of each other. A fourth pin 114 of the first basic pattern P1 is arranged in a same direction as a first pin 111 of the second basic pattern P2. A sixth pin 116 of the first basic pattern P is arranged in a same direction as a fifth pin 115 of the second basic pattern P2.

The two basic patterns share four ground pins 12 that are sequentially spaced apart. Two shared ground pins 12 are located between the sixth pin 116 of the first basic pattern P1 and the first pin 111 of the second basic pattern P2, and the other two shared ground pins 12 are located between the fourth pin 114 of the first basic pattern P1 and the fifth pin 115 of the second basic pattern P2. Specifically, an eleventh ground pin 1211 of the first basic pattern P1 and a first ground pin 1201 of the second basic pattern P are a shared ground pin, a tenth ground pin 1210 of the first basic pattern P and a second ground pin 1202 of the second basic pattern P2 are a shared ground pin, a ninth ground pin 1209 of the first basic pattern P and a third ground pin 1203 of the second basic pattern P are a shared ground pin, and an eighth ground pin 1208 of the first basic pattern P and a fourth ground pin 1204 of the second basic pattern P2 are a shared ground pin.

It may be understood that the package substrate configured with the basic patterns P described in FIG. 2, FIG. 3, and FIG. 4 and the package substrate configured with the pinmap combinations described in FIG. 5 to FIG. 10 may be configured to match a chip like a CPU (central processing unit, central processing unit), a GPU (graphics processing unit, graphics processing unit), or an NPU (neural-network processing unit, neural-network processing unit), that is, a pinmap formed based on a basic pattern P in a pin region of the package substrate described in the foregoing embodiments can be used for a DDR interface on the CPU chip, the NPU chip, or the GPU chip. For the CPU chip, a DDR signal may be connected to a memory chip (DIMM) on a memory module DIMM through a signal pin 11 and PCB wiring.

The following briefly describes a matching manner between the pinmap on the package substrate and the CPU chip.

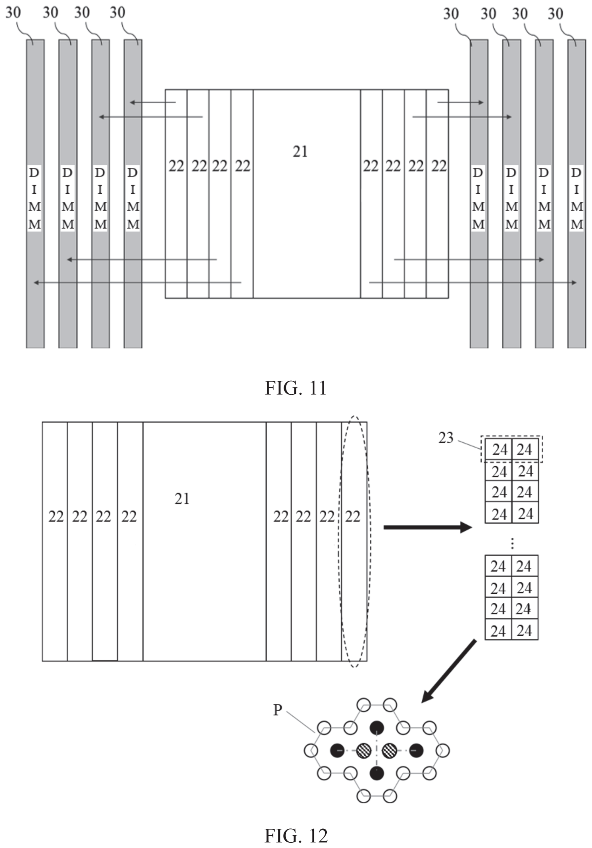

FIG. 11 is a diagram of a hardware architecture of a CPU DDR interface according to an embodiment of this application.

As shown in FIG. 11, a CPU chip 21 includes a plurality of memory channels (DDR channel) 22, and each memory channel 22 may separately drive and connect to a corresponding memory module 30. Without loss of generality, FIG. 11 is illustrated by using a CPU chip 21 including eight memory channels 22 as an example. It should be understood that, in other specific implementation, a quantity of channels of the CPU and a quantity of memory modules correspondingly connected to each channel may be set based on an actual requirement. Specific implementation may be based on the conventional technology, and details are not described in this specification.

Each memory channel 22 may include a plurality of DDR bytes (bytes) 23, and each byte includes two nibbles (nibbles) 24. A memory bandwidth of a memory channel 22 is generally 32 bits or 64 bits. It may be understood that a memory channel 22 with a 32-bit bandwidth may include four bytes 23, and a memory channel 22 with a 64-bit bandwidth may include eight bytes 23. This is not limited in embodiments of this application.

FIG. 12 is a diagram of a relationship between a CPU DDR interface and a basic pattern P according to an embodiment of this application.

As shown in FIG. 12, each Nibble 24 includes six data signals: four DQ data signals and a pair of DQS differential clock signals. Herein, the six data signals of each Nibble 24 and GND pins at a periphery of the six data signals may constitute a pinmap pattern P in a cross-shaped form described in the foregoing embodiments. In other words, each byte 23 includes 12 data signals: eight DQ data signals and two pairs of DQS differential clock signals. Correspondingly, the 12 data signals of each Byte 23 and GND pins at a periphery of the data signals may constitute a Pinmap Pattern combination described in FIG. 5 to FIG. 10 in the foregoing embodiments.

In a specific implementation, signal pins and ground pins at a periphery of the signal pins corresponding to all memory channels 22 of the CPU chip 21 may be combined and arranged based on one nibble, to form a complete DDR channel pinmap (DDR channel pinmap), so that a region of the memory channels 22 of the CPU chip 21 has high pinmap density, and small electromagnetic crosstalk between the signal pins, thereby ensuring stable signal transmission between the CPU 21 and the memory module 30. In a specific implementation, the memory module 30 may be a dual in-line storage module (dual in-line memory module, DIMM). This is not limited in this embodiment of this application.

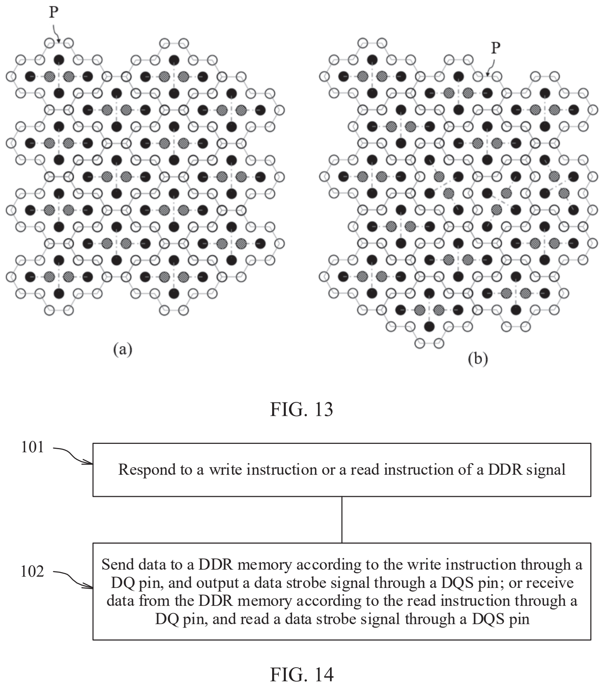

FIG. 13 is a diagram of two manners of combining a plurality of basic patterns according to an embodiment of this application. In a combination manner shown in (a) in FIG. 13, each basic pattern P is correspondingly concatenated after translation. For two adjacent columns of basic patterns P, a fourth pin of each basic pattern P in the left column and a first pin of each basic pattern P in the right column are sequentially spaced apart in a second direction. In a combination manner shown in (b) in FIG. 13, a part of basic patterns P are correspondingly concatenated after translation, and the other part of basic patterns P are correspondingly concatenated after rotation and translation.

As shown in FIG. 13, based on a staggered arrangement of pins in rows and columns in a pin region of a package substrate 1, the DDR channel pinmap formed by combining basic patterns provided in this embodiment of this application is used, each group of adjacent basic patterns P may share a ground pin at a periphery, and overall pinmap density is more compact and appropriate. Based on a structure feature of a pinmap pattern in a cross-shaped form, data signal pins a of the DDR channel pinmap are far away from each other, and each data signal pin a has no adjacent crosstalk source, thereby effectively avoiding an impact of electromagnetic crosstalk between adjacent data signal pins a.

The CPU chip described in the foregoing embodiments may be used in DDR systems of different generations, to implement data storage and reading, for example, but not limited to, a DDR4 SDRAM (a fourth generation double data rate synchronous dynamic random access memory) and a DDR5 SDRAM (a fifth generation double data rate synchronous dynamic random access memory). Based on different DDR chip data bus widths, the DDR4 SDRAM includes two types: X8 and X16, and the DDR5 SDRAM includes three types: X4, X8, and X16. A chip bit width of an X4 device is 4 bits, a chip bit width of an X8 device is 8 bits, and a chip bit width of an X16 device is 16 bits.

A control signal pin b of the basic pattern P is usually defined as a DQS signal pin on a CPU chip side. In another specific implementation, for example, in an X8 scenario, if a DM signal needs to be transmitted, DQS 0 to DQS 3 pins may be configured to reuse a channel for a DM signal. The DM signal indicates validity of each DQ data signal to mask and selectively write each data bit. In a write operation (WR OP), the CPU sends a DM signal, a DQ signal, and a DQS signal to the DRAM at the same time. In this case, the DM signal and DQ signal are sampled at a rising/falling edge of a DQS clock signal. When the control signal pins are for transmitting a DM signal, the DM signal is sampled as a low level, electromagnetic crosstalk that is actually generated is low, and data transmission of DQ data signal pins is not affected.

It should be noted that the foregoing basic pattern P arranged in the cross shape may be applied to a chip package structure design for information connection with a DDR memory, and may be further applied to another chip or connector based on a DDR interface in addition to a CPU chip, a GPU chip, or an NPU chip. Correct signal transmission and data reading/writing are ensured based on good anti-crosstalk performance, thereby providing technical assurance for high-performance and reliable DDR systems.

Certainly, for another parallel bus scenario, the pinmap formed by basic patterns P arranged in the cross shape is used for a corresponding physical line interface, for example, but not limited to, a parallel camera, a parallel external storage device, or a parallel printer, and an input/output device that transmits data signals and control signals through a parallel bus.

Based on a hardware architecture of a CPU DDR interface shown in FIG. 11, an embodiment of this application further provides a method for reading/sending data by a CPU. FIG. 14 is a schematic flowchart of a method for reading/sending data by a CPU according to an embodiment of this application.

As shown in FIG. 14, the method includes the following steps.

Step 101: Respond to a write instruction or a read instruction of a DDR signal.

In a specific implementation, when a CPU or another device needs to read data in a memory, a memory controller sends a read command to a memory module, and specifies an address from which the data is read. When the CPU or another device needs to write the data into the memory, the memory controller sends a write command to the memory module, and provides a to-be-written data and a target address Herein, the memory controller CPU or a part of an independent chip located on a mainboard is configured to control a read/write operation of the memory module, and process a memory access request from the CPU or another device.

Step 102: Send data to a DDR memory according to the write instruction through a DQ pin, and output a data strobe signal through a DQS pin, that is, provide a data clock signal for the DDR memory, so that the DDR memory correctly receives and parses the data sent by the CPU; or receive data from the DDR memory according to the read instruction through a DQ pin, and read a data strobe signal through a DQS pin, that is, provide a data clock signal for the CPU, so that the CPU correctly samples and parses the data transmitted from the DDR memory.

Specifically, during data transmission, there is a corresponding time sequence relationship between a DQS pin and a corresponding DQ pin, and data sampling and transmission occur on an edge (a rising edge or a falling edge) of a data clock signal. When sending data, after receiving a command, the memory module writes the data into a storage unit of a specified address. When reading data, after receiving the command, the memory module transmits the requested data to the CPU through a data bus.

DQ pins (data signal pins) and DQS pins (data strobe signal pins) of the CPU chip are arranged in a basic pattern. The basic pattern includes six signal pins: a first pin 111, a second pin 112, a third pin 113, a fourth pin 114, a fifth pin 115, and a sixth pin 116. The first pin 111, fourth pin 114, fifth pin 115, and sixth pin 116 are DQ pins (pins shown as solid circles in the figure). The second pin 111 and third pin 113 are DQS pins (pins filled with slashes in the figure). The six signal pins are arranged in a cross-shaped form. The first pin 111, second pin 112, third pin 113, and fourth pin 114 are sequentially spaced apart in a first direction X, and the fifth pin 115 and sixth pin 116 in the six pins are spaced apart in a second direction Y. The fifth pin 115 and the sixth pin 116 are disposed on a perpendicular line of a connection line between the second pin 112 and the third pin 113, and are respectively located on two sides of the second pin 112 and the third pin 113.

A pinmap combination corresponding to one byte is used as an example. Eight data signal pins are a DQ 0, a DQ 1, a DQ 2, a DQ 3, a DQ 4, a DQ 5, a DQ 6, and a DQ 7, configured to respectively send or receive data of a data bit 0 to a data bit 7. Four data clock signal pins are a DQS 0, a DQS 1, a DQS 2, and a DQS 3. The DQS 0 and DQS 1 are a pair of differential pair pins, and the DQS 2 and the DQS 3 are a pair of differential pair pins, respectively configured to perform timing and synchronization on data during data transmission.

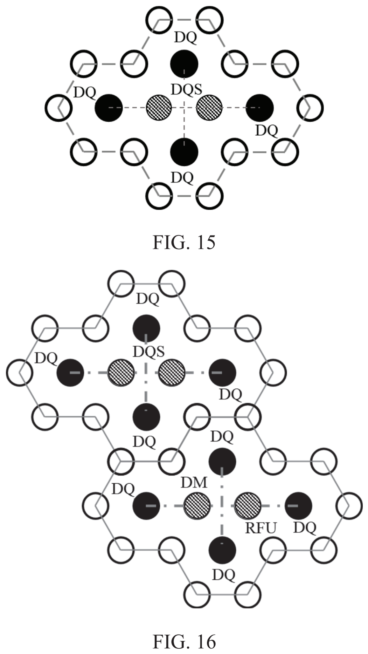

FIG. 15 is a diagram of a pin configuration in a CPU application scenario according to an embodiment of this application.

For an X4 scenario, the pin configuration may be shown in FIG. 15. During a write operation and a read operation (WR OP/RD OP), specific behavior of signal pins is as follows:
Write operation: A CPU sends a DQ signal and a DQS signal to a DRAM. The DQS signal is aligned with the DQ signal at a center. On a DRAM side, the DQ signal is sampled at positions on a rising edge and a falling edge of the DQS clock signal, and the sampled signal is stored in the DRAM.

Read operation: The DRAM sends a DQ signal and a DQS signal to the CPU. The DQS signal is aligned with the DQ signal on an edge. A CPU side first adjusts a phase relationship between the DQS signal and the DQ signal to align the DQS signal with the DQ signal at a center, then performs sampling, and transmits the sampled signal to a back end for processing.

FIG. 16 is a diagram of a pin configuration in another CPU application scenario according to an embodiment of this application.

For a X8 scenario, the pin configuration may be shown in FIG. 16. During a write operation and a read operation (WR OP/RD OP), a RFU pin in the figure is standby pin for protection (Reserved For Future Use), and specific behavior of other signal pins are as follows:
Write operation: A CPU sends a DQ signal, a DM signal, and a DQS signal to a DRAM. The DQS signal is aligned with the DQ signal and the DM signal at a center. On a DRAM side, the DQ signal and the DM signal is sampled at positions on a rising edge and a falling edge of the DQS signal, and the sampled signal is stored in the DRAM. It should be understood that, when the DM signal is sampled as a low level, a DQ signal sampled together with the DM signal is masked, and is not written into the DRAM.

Read operation: The DRAM sends a DQ signal and a DQS signal to the CPU. The DQS signal is aligned with the DQ signal on an edge. A CPU side first adjusts a phase relationship between the DQS signal and the DQ signal to align the DQS signal with the DQ signal at a center, then performs sampling, and transmits the sampled signal to a back end for processing.

During actual application, a basic pattern in a cross-shaped form can improve pinmap density, reduce a package area, and effectively reduce electromagnetic crosstalk between pins, to support a higher DDR running rate.

It should be noted that, in a specific implementation, different pin configurations and signal allocation manners may be used for the foregoing signal pins, and may be specifically determined based on types and specifications of the CPU chip and the DDR chip, and a control mechanism of a corresponding memory controller. This is not limited in embodiments of this application.

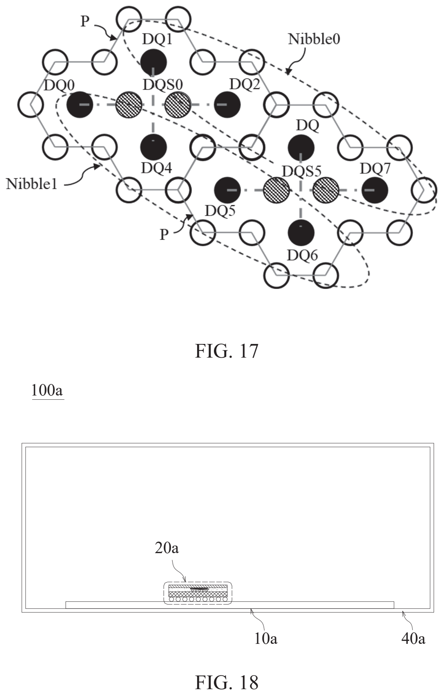

FIG. 17 is a diagram of a pin configuration in still another CPU application scenario according to an embodiment of this application. As shown in FIG. 17, a pinmap combination formed by two basic patterns P may support different mixed arrangements of DQ signals of nibbles/bytes. Four data signal pins corresponding to a Nibble 0 are a DQ 0, a DQ 1, a DQ 2, and a DQ 3, and the four data signal pins corresponding to a Nibble 1 are a DQ 4, a DQ 5, a DQ 6, and a DQ 7. The DQ 0, DQ 1, and DQ 2 of the Nibble 0 and the DQ 4 of the Nibble 1 are configured in a basic pattern P, and the DQ 3 of the Nibble 0 and the DQ 5, DQ 6, and DQ 7 of the Nibble 1 are configured in another basic pattern P.

In addition, based on the chip 20 in which a basic pattern arranged in a cross shape is used as described in the foregoing embodiments, an embodiment of this application further provides a signal transmission method applied to a chip. A plurality of pinmap patterns are disposed in a pin region of a package substrate 4 of the chip 20. At least two of the plurality of pinmap patterns are basic patterns P, and the basic pattern P includes six signal pins 11. A first pin 111, a second pin 112, a third pin 113, and a fourth pin 114 in the six signal pins 11 are sequentially spaced apart in a first direction X, and a fifth pin 115 and a sixth pin 116 in the six signal pins 11 are spaced apart in a second direction Y. The fifth pin 115 and the sixth pin 116 are respectively located on two sides of a connection line between the second pin 112 and the third pin 113. The first pin 111, the fourth pin 114, the fifth pin 115, and the sixth pin 116 are data signal pins, and the second pin 112 and the third pin 113 are control signal pins. The first direction X is different from the second direction Y. In a specific implementation, the chip may be the CPU chip described above, or may be another chip or connector based on a DDR interface. This is not limited in this embodiment of this application.

The signal transmission method includes the following steps: Transmit a data signal through the first pin 111, the fourth pin 1114, the fifth pin 115, and the sixth pin 116, and transmitting a control signal through the second pin 112 and the third pin 113. The basic pattern P arranged in the cross shape ensures correct signal transmission of the chip based on good anti-crosstalk performance, thereby providing technical assurance for high-performance and reliable system applications.

An embodiment of this application further provides an electronic device. FIG. 18 is a diagram of an architecture of an electronic device according to an embodiment of this application. The electronic device 100a includes a housing 40a and a circuit board 10a and a CPU 20a that are disposed in the housing 40a. The CPU 20a is disposed on the circuit board 10a. A pin region on a package substrate of the CPU 20a may include the basic pattern P described in FIG. 2, FIG. 3, and FIG. 4, or may include the pinmap combination described in FIG. 5 to FIG. 10. Based on the basic pattern in the cross-shaped form provided in this implementation solution, a pinmap of the basic pattern can improve pinmap density, reduce a package area, reduce DDR memory signal crosstalk, and improve computing performance of a computing device.

It should be understood that other functions of the computing device are not a core invention point of this application. Therefore, details are not described in this specification.

As an important technical means of a chip packaging technology, the pinmap pattern in the cross-shaped form provided in this implementation solution has a wide application prospect, and will play an increasingly important role in different electronic devices, for example, but not limited to, computing devices such as a server, a super computer, and an Ethernet switch, and may also be applied to terminal devices such as a vehicle, a mobile phone, and a notebook computer.

Ordinal numbers "first" and "second" used in this specification are merely used to describe components or structures with a same function in the technical solutions. It may be understood that use of the ordinal numbers "first" and "second" does not constitute a limitation on understanding of the technical solutions claimed in this application.

The foregoing are merely preferred implementations of the present invention. It should be noted that a person of ordinary skill in the art may make several improvements and modifications without departing from the principle of the present invention, and the improvements and modifications shall be regarded as falling within the protection scope of the present invention.

## Claims

1. A chip, comprising a die and a package substrate, wherein the die is disposed on the package substrate, and a plurality of pinmap patterns are disposed in a pin region of the package substrate;
in the plurality of pinmap patterns, at least two pinmap patterns are basic patterns comprising six signal pins;
a first pin, a second pin, a third pin, and a fourth pin in the six signal pins are sequentially spaced apart in a first direction, a fifth pin and a sixth pin in the six signal pins are spaced apart in a second direction, and the fifth pin and the sixth pin are respectively located on two sides of a connection line between the second pin and the third pin; and
the first pin, the fourth pin, the fifth pin, and the sixth pin are data signal pins, the second pin and the third pin are control signal pins, and the first direction is different from the second direction.

2. The chip according to claim 1, wherein the fifth pin and the sixth pin are disposed on a perpendicular line of the connection line between the second pin and the third pin, and the first direction is perpendicular to the second direction.

3. The chip according to claim 2, wherein the fifth pin and the sixth pin are disposed on a midperpendicular line of the connection line between the second pin and the third pin.

4. The chip according to any one of claims 1 to 3, wherein the basic pattern is of a centrosymmetric structure or an axisymmetric structure.

5. The chip according to any one of claims 1 to 4, wherein pins in the pin region are arranged in an array, and pins in rows and columns are staggered.

6. The chip according to any one of claims 1 to 5, wherein the pins in the pin region are arranged in a triangular grid shape, and connection lines between the pin and two adjacent pins of the pin constitute an equilateral triangle.

7. The chip according to any one of claims 1 to 6, wherein the basic pattern further comprises a ground pin, and the ground pin is arranged at a periphery of the six signal pins.

8. The chip according to claim 7, wherein there are 14 ground pins in the basic pattern, and the 14 ground pins are sequentially spaced apart at the periphery of the six signal pins; in the first direction, a first ground pin is located on a side of the first pin, an eighth ground pin is located on a side of the fourth pin, and a second ground pin, a third ground pin, a fourth ground pin, a fifth ground pin, a sixth ground pin, and a seventh ground pin are sequentially arranged between the first ground pin and the eighth ground pin; and a ninth ground pin, a tenth ground pin, an eleventh ground pin, a twelfth ground pin, a thirteenth ground pin, and a fourteenth ground pin are sequentially arranged between the eighth ground pin and the first ground pin.

9. The chip according to claim 8, wherein two basic patterns are adjacently disposed, one is a first basic pattern, the other is a second basic pattern, and adjacent sides of the first basic pattern and the second basic pattern share a ground pin.

10. The chip according to claim 9, wherein the first basic pattern and the second basic pattern are translated patterns of each other, and an eighth ground pin of the first basic pattern and a first ground pin of the second basic pattern are a shared ground pin.

11. The chip according to claim 9, wherein the first basic pattern and the second basic pattern are translated patterns of each other, a twelfth ground pin of the first basic pattern and a fourth ground pin of the second basic pattern are a shared ground pin, and an eleventh ground pin of the first basic pattern and a fifth ground pin of the second basic pattern are a shared ground pin.

12. The chip according to claim 9, wherein the first basic pattern and the second basic pattern are translated patterns of each other, a seventh ground pin of the first basic pattern and a first ground pin of the second basic pattern are a shared ground pin, and an eighth ground pin of the first basic pattern and a fourteenth ground pin of the second basic pattern are a shared ground pin.

13. The chip according to claim 9, wherein the first basic pattern and the second basic pattern are translated patterns of each other, a twelfth ground pin of the first basic pattern and a second ground pin of the second basic pattern are a shared ground pin, an eleventh ground pin of the first basic pattern and a third ground pin of the second basic pattern are a shared ground pin, a tenth ground pin of the first basic pattern and a fourth ground pin of the second basic pattern are a shared ground pin, and a ninth ground pin of the first basic pattern and a fifth ground pin of the second basic pattern are a shared ground pin.

14. The chip according to claim 9, wherein the first basic pattern and the second basic pattern are translated patterns of each other, an eleventh ground pin of the first basic pattern and a first ground pin of the second basic pattern are a shared ground pin, a tenth ground pin of the first basic pattern and a second ground pin of the second basic pattern are a shared ground pin, a ninth ground pin of the first basic pattern and a third ground pin of the second basic pattern are a shared ground pin, and an eighth ground pin of the first basic pattern and a fourth ground pin of the second basic pattern are a shared ground pin.

15. The chip according to claim 9, wherein the first basic pattern and the second basic pattern are translated and rotated patterns of each other, a fifth ground pin of the first basic pattern and a fifth ground pin of the second basic pattern are a shared ground pin, a sixth ground pin of the first basic pattern and a fourth ground pin of the second basic pattern are a shared ground pin, a seventh ground pin of the first basic pattern and a third ground pin of the second basic pattern are a shared ground pin, and an eighth ground pin of the first basic pattern and a second ground pin of the second basic pattern are a shared ground pin.

16. The chip according to any one of claims 8 to 15, wherein in the basic pattern, connection lines between the data signal pin adjacent to two adjacent ground pins and the two adjacent ground pins constitute an equilateral triangle.

17. The chip according to any one of claims 1 to 16, wherein the first pin, the fourth pin, the fifth pin, and the sixth pin are single-ended signal pins, and the second pin and the third pin are a pair of differential signal pins.

18. The chip according to any one of claims 1 to 17, wherein the chip is a central processing unit, the central processing unit is configured with a plurality of memory channels, the memory channel comprises a plurality of bytes, the byte corresponds to two basic patterns, and the data signal pin in the basic pattern is for transmitting a data signal of the corresponding byte.

19. An electronic device, comprising a housing and a circuit board disposed in the housing, wherein a chip is disposed on the circuit board, the chip is the chip according to claim 1 or 18, and a signal pin of the chip is electrically connected to the circuit board.

20. A chip manufacturing method, wherein the chip manufacturing method comprises: disposing a die on a package substrate, and assembling the die and the package substrate to form the chip, wherein a plurality of pinmap patterns are disposed in a pin region of the package substrate;
in the plurality of pinmap patterns, at least two pinmap patterns are basic patterns comprising six signal pins;
a first pin, a second pin, a third pin, and a fourth pin in the six signal pins are sequentially spaced apart in a first direction, a fifth pin and a sixth pin in the six signal pins are spaced apart in a second direction, and the fifth pin and the sixth pin are respectively located on two sides of a connection line between the second pin and the third pin; and
the first pin, the fourth pin, the fifth pin, and the sixth pin are data signal pins, the second pin and the third pin are control signal pins, and the first direction is different from the second direction.

21. The chip manufacturing method according to claim 20, wherein the fifth pin and the sixth pin are disposed on a perpendicular line of the connection line between the second pin and the third pin, and the first direction is perpendicular to the second direction.

22. The chip manufacturing method according to claim 21, wherein the fifth pin and the sixth pin are configured on a midperpendicular line of the connection line between the second pin and the third pin, and the basic pattern is of a centrosymmetric structure or an axisymmetric structure.

23. The chip manufacturing method according to any one of claims 20 to 22, wherein pins in the pin region are arranged in an array, and pins in rows and columns are staggered; and the pins in the pin region are arranged in a triangular grid shape, and connection lines between the pin and two adjacent pins of the pin constitute an equilateral triangle.

24. The chip manufacturing method according to any one of claims 20 to 23, wherein the basic pattern further comprises a ground pin, there are 14 ground pins, and the 14 ground pins are sequentially spaced apart at the periphery of the six signal pins; in the first direction, a first ground pin is located on a side of the first pin, an eighth ground pin is located on a side of the fourth pin, and a second ground pin, a third ground pin, a fourth ground pin, a fifth ground pin, a sixth ground pin, and a seventh ground pin are sequentially arranged between the first ground pin and the eighth ground pin; and a ninth ground pin, a tenth ground pin, an eleventh ground pin, a twelfth ground pin, a thirteenth ground pin, and a fourteenth ground pin are sequentially arranged between the eighth ground pin and the first ground pin.

25. The chip manufacturing method according to claim 24, wherein two basic patterns are adjacently disposed, one is a first basic pattern, the other is a second basic pattern, and adjacent sides of the first basic pattern and the second basic pattern share a ground pin.

26. The chip manufacturing method according to claim 25, wherein the first basic pattern and the second basic pattern are translated patterns of each other, and an eighth ground pin of the first basic pattern and a first ground pin of the second basic pattern are a shared ground pin.

27. The chip manufacturing method according to claim 25, wherein the first basic pattern and the second basic pattern are translated patterns of each other, a twelfth ground pin of the first basic pattern and a fourth ground pin of the second basic pattern are a shared ground pin, and an eleventh ground pin of the first basic pattern and a fifth ground pin of the second basic pattern are a shared ground pin.

28. The chip manufacturing method according to claim 25, wherein the first basic pattern and the second basic pattern are translated patterns of each other, a seventh ground pin of the first basic pattern and a first ground pin of the second basic pattern are a shared ground pin, and an eighth ground pin of the first basic pattern and a fourteenth ground pin of the second basic pattern are a shared ground pin.

29. The chip manufacturing method according to claim 25, wherein the first basic pattern and the second basic pattern are translated patterns of each other, a twelfth ground pin of the first basic pattern and a second ground pin of the second basic pattern are a shared ground pin, an eleventh ground pin of the first basic pattern and a third ground pin of the second basic pattern are a shared ground pin, a tenth ground pin of the first basic pattern and a fourth ground pin of the second basic pattern are a shared ground pin, and a ninth ground pin of the first basic pattern and a fifth ground pin of the second basic pattern are a shared ground pin.

30. The chip manufacturing method according to claim 25, wherein the first basic pattern and the second basic pattern are translated patterns of each other, an eleventh ground pin of the first basic pattern and a first ground pin of the second basic pattern are a shared ground pin, a tenth ground pin of the first basic pattern and a second ground pin of the second basic pattern are a shared ground pin, a ninth ground pin of the first basic pattern and a third ground pin of the second basic pattern are a shared ground pin, and an eighth ground pin of the first basic pattern and a fourth ground pin of the second basic pattern are a shared ground pin.

31. The chip manufacturing method according to claim 25, wherein the first basic pattern and the second basic pattern are translated and rotated patterns of each other, a fifth ground pin of the first basic pattern and a fifth ground pin of the second basic pattern are a shared ground pin, a sixth ground pin of the first basic pattern and a fourth ground pin of the second basic pattern are a shared ground pin, a seventh ground pin of the first basic pattern and a third ground pin of the second basic pattern are a shared ground pin, and an eighth ground pin of the first basic pattern and a second ground pin of the second basic pattern are a shared ground pin.

32. A signal transmission method, wherein the signal transmission method is applied to a chip, the chip comprises a package substrate, a plurality of pinmap patterns are disposed in a pin region of the package substrate; in the plurality of pinmap patterns, at least two pinmap patterns are basic patterns comprising six signal pins; a first pin, a second pin, a third pin, and a fourth pin in the six signal pins are sequentially spaced apart in a first direction, a fifth pin and a sixth pin in the six signal pins are spaced apart in a second direction, and the fifth pin and the sixth pin are respectively located on two sides of a connection line between the second pin and the third pin; the first pin, the fourth pin, the fifth pin, and the sixth pin are data signal pins, the second pin and the third pin are control signal pins, the first direction is different from the second direction; and the method comprises:
transmitting a data signal through the first pin, the fourth pin, the fifth pin, and the sixth pin, and transmitting a control signal through the second pin and the third pin.

33. The signal transmission method according to claim 32, wherein the fifth pin and the sixth pin are disposed on a perpendicular line of the connection line between the second pin and the third pin, and the first direction is perpendicular to the second direction.

34. The signal transmission method according to claim 33, wherein the fifth pin and the sixth pin are configured on a midperpendicular line of the connection line between the second pin and the third pin, and the basic pattern is of a centrosymmetric structure or an axisymmetric structure.

35. The signal transmission method according to any one of claims 32 to 34, wherein pins in the pin region are arranged in an array, and pins in rows and columns are staggered; and the pins in the pin region are arranged in a triangular grid shape, and connection lines between the pin and two adjacent pins of the pin constitute an equilateral triangle.

36. The signal transmission method according to any one of claims 32 to 35, wherein the basic pattern further comprises a ground pin, there are 14 ground pins, and the 14 ground pins are sequentially spaced apart at a periphery of the six signal pins; in the first direction, a first ground pin is located on a side of the first pin, an eighth ground pin is located on a side of the fourth pin, and a second ground pin, a third ground pin, a fourth ground pin, a fifth ground pin, a sixth ground pin, and a seventh ground pin are sequentially arranged between the first ground pin and the eighth ground pin; and a ninth ground pin, a tenth ground pin, an eleventh ground pin, a twelfth ground pin, a thirteenth ground pin, and a fourteenth ground pin are sequentially arranged between the eighth ground pin and the first ground pin.

37. The signal transmission method according to claim 36, wherein two basic patterns are adjacently disposed, one is a first basic pattern, the other is a second basic pattern, and adjacent sides of the first basic pattern and the second basic pattern share a ground pin.

38. The signal transmission method according to claim 37, wherein the first basic pattern and the second basic pattern are translated patterns of each other, and an eighth ground pin of the first basic pattern and a first ground pin of the second basic pattern are a shared ground pin.

39. The signal transmission method according to claim 37, wherein the first basic pattern and the second basic pattern are translated patterns of each other, a twelfth ground pin of the first basic pattern and a fourth ground pin of the second basic pattern are a shared ground pin, and an eleventh ground pin of the first basic pattern and a fifth ground pin of the second basic pattern are a shared ground pin.

40. The signal transmission method according to claim 37, wherein the first basic pattern and the second basic pattern are translated patterns of each other, a seventh ground pin of the first basic pattern and a first ground pin of the second basic pattern are a shared ground pin, and an eighth ground pin of the first basic pattern and a fourteenth ground pin of the second basic pattern are a shared ground pin.

41. The signal transmission method according to claim 37, wherein the first basic pattern and the second basic pattern are translated patterns of each other, a twelfth ground pin of the first basic pattern and a second ground pin of the second basic pattern are a shared ground pin, an eleventh ground pin of the first basic pattern and a third ground pin of the second basic pattern are a shared ground pin, a tenth ground pin of the first basic pattern and a fourth ground pin of the second basic pattern are a shared ground pin, and a ninth ground pin of the first basic pattern and a fifth ground pin of the second basic pattern are a shared ground pin.

42. The signal transmission method according to claim 37, wherein the first basic pattern and the second basic pattern are translated patterns of each other, an eleventh ground pin of the first basic pattern and a first ground pin of the second basic pattern are a shared ground pin, a tenth ground pin of the first basic pattern and a second ground pin of the second basic pattern are a shared ground pin, a ninth ground pin of the first basic pattern and a third ground pin of the second basic pattern are a shared ground pin, and an eighth ground pin of the first basic pattern and a fourth ground pin of the second basic pattern are a shared ground pin.

43. The signal transmission method according to claim 37, wherein the first basic pattern and the second basic pattern are translated and rotated patterns of each other, a fifth ground pin of the first basic pattern and a fifth ground pin of the second basic pattern are a shared ground pin, a sixth ground pin of the first basic pattern and a fourth ground pin of the second basic pattern are a shared ground pin, a seventh ground pin of the first basic pattern and a third ground pin of the second basic pattern are a shared ground pin, and an eighth ground pin of the first basic pattern and a second ground pin of the second basic pattern are a shared ground pin.
